# EUROPEAN PATENT APPLICATION

(11) **EP 4 191 641 A1**
(43) Date of publication of application: **07.06.2023**
(21) Application number: 20949889.8
(22) Date of filing: 21.08.2020
(51) Int. Cl.: H01L 21/336

(54) **INTEGRATED CIRCUIT**

(71) Applicant: Huawei Technologies Co., Ltd., Shenzhen, Guangdong 518129 (CN)
(72) Inventor: QIN, Xi, Shenzhen, Guangdong 518129 (CN); GU, Xun, Shenzhen, Guangdong 518129 (CN); TIAN, Yu, Shenzhen, Guangdong 518129 (CN)
(74) Representative: Gill Jennings & Every LLP
(86) International application number: PCT/CN2020/110475
(87) International publication number: WO 2022/036680

(57) **Abstract**

This application provides an integrated circuit, including: a first metal-oxide semiconductor field-effect transistor (FET). A first valid gate and a second valid gate are disposed in the first FET, and a first redundant gate is disposed between the first valid gate and the second valid gate; the first valid gate, the second valid gate, and the first redundant gate surround a periphery of a first channel; the first valid gate and the second valid gate are connected to a gate of the first FET; the first channel on both sides of the first valid gate and the first channel on both sides of the second valid gate are respectively connected to a source and a drain of the first FET; and the first redundant gate is connected to a redundant potential or is suspended. Through a structure of the redundant gate disposed between two valid gates, current density of a GAA transistor can be reduced, so that heat dissipation performance of the GAA transistor is further improved.

## Description

### TECHNICAL FIELD

This application relates to an integrated circuit, and in particular, to an integrated circuit for improving heat dissipation performance based on a gate all around field effect transistor (GAA: gate all around field effect transistor) process.

### BACKGROUND

An integrated circuit is also referred to as a chip, and is core driving force of development of modem science and technologies. As the integrated circuit evolves from a planar field effect transistor (Planar FET) process to a GAA process, a transistor used as a base unit of the integrated circuit changes from an original planar structure to a three-dimensional structure, bringing a smaller transistor size and a smaller area of the integrated circuit. As a degree of integration is improved, higher thermal density is brought. Therefore, a heat dissipation problem that troubles the chip field becomes more prominent in the GAA process.

### SUMMARY

This application provides an integrated circuit that relates to a gate all around field effect transistor GAA process structure, to improve heat dissipation performance of a chip apparatus.

According to a first aspect, this application provides an integrated circuit, including a first gate all around field effect transistor GAA. A first valid gate, a second valid gate, and a first redundant gate are disposed in the first GAA, and the first redundant gate is disposed between the first valid gate and the second valid gate; the first valid gate, the second valid gate, and the first redundant gate surround a periphery of a first channel; the first valid gate and the second valid gate are connected to a gate of the first GAA; both sides of the first channel surrounded by the first valid gate and the second valid gate are separately connected to a source and a drain of the first GAA; and the first redundant gate is connected to a redundant potential or is suspended.

In the foregoing technical solution, through a structure of the redundant gate disposed between two valid gates, current density of the GAA can be reduced, so that heat dissipation performance of the GAA is improved.

With reference to any one of the foregoing possible implementations, in a possible implementation, a second channel is further included, and the first channel and the second channel are arranged in parallel in a direction perpendicular to a substrate of the first GAA. The first valid gate, the second valid gate, and the first redundant gate surround a periphery of the second channel, and two sides of the second channel surrounded by the first valid gate and the second valid gate are separately connected to a source and a drain of the first GAA.

In the foregoing technical solution, the second channel arranged in parallel is introduced, so that performance of the GAA is further improved, and in addition, a heat dissipation gain brought by introduction of a redundant gate structure is further improved.

With reference to any one of the foregoing possible implementations, in a possible implementation, a second redundant gate is further included, the second redundant gate is located between the first valid gate and the first redundant gate, and the second redundant gate is connected to the redundant potential or is suspended.

In the foregoing technical solution, based on the first redundant gate, the second redundant gate is further disposed between the two valid gates, so that current density of a unit FET can be further reduced, and heat dissipation performance of the GAA is further improved.

With reference to any one of the foregoing possible implementations, in a possible implementation, the first GAA is N-type, and the redundant potential is coupled to a ground terminal of the integrated circuit.

In the foregoing technical solution, a part of heat generated by the GAA is exported by a redundant gate of an NMOS transistor based on a GAA structure to an outer side of the integrated circuit by using a connection wire of a ground terminal, so that the heat dissipation performance of the GAA can be further improved.

With reference to any one of the foregoing possible implementations, in a possible implementation, a first guard ring is further included, the first guard ring is disposed on one or more sides of the N-type first GAA, and the first guard ring is a P-type guard ring.

In the foregoing technical solutions, because the guard ring is introduced, a substrate of an N-type transistor based on the GAA structure may be connected to the ground terminal of the integrated circuit by using the P-type guard ring, and disposing may be performed on a single side or a plurality of sides based on an actual chip area layout. In this way, heat dissipation performance of the N-type transistor based on a P-type guard ring structure can be further improved based on any one of the foregoing possible redundant gate structures.

With reference to any one of the foregoing possible implementations, in a possible implementation, a second guard ring is further included, the first guard ring is disposed between the second guard ring and the N-type first GAA, and the second guard ring is an N-type guard ring.

In the foregoing technical solutions, because the second guard ring is introduced, heat dissipation performance of the N-type transistor based on the GAA process can be further improved.

With reference to any one of the foregoing possible implementations, in a possible implementation, the first GAA is P-type, and the redundant potential is coupled to a power terminal of the integrated circuit.

In the foregoing technical solution, a part of generated heat is exported to the outer side of the integrated circuit based on a redundant gate of the P-type GAA by using a connection wire on the power terminal of the integrated circuit, so that heat dissipation performance can be further improved.

With reference to any one of the foregoing possible implementations, in a possible implementation, a first guard ring is further included, the first guard ring is disposed on one or more sides of the P-type first GAA, and the first guard ring is an N-type guard ring.

In the foregoing technical solutions, because the guard ring is introduced, a substrate of the P-type GAA may be connected to the power terminal of the integrated circuit by using the N-type guard ring, and disposing may be performed on a single side or a plurality of sides based on an actual chip area layout. In this way, heat dissipation performance of the P-type GAA based on the N-type guard ring structure can be further improved based on any one of the foregoing possible redundant gate structures.

With reference to any one of the foregoing possible implementations, in a possible implementation, a second guard ring is further included, the first guard ring is disposed between the second guard ring and a PMOS transistor, and the second guard ring is a P-type guard ring.

In the foregoing technical solution, heat dissipation performance of the P-type GAA can be further improved due to introduction of the second guard ring.

With reference to any one of the foregoing possible implementations, in a possible implementation, one or more openings are disposed on the first guard ring.

In the foregoing technical solutions, the guard ring is introduced more flexibly, and both opened disposing and closed disposing can improve heat dissipation performance of the first GAA.

With reference to any one of the foregoing possible implementations, in a possible implementation, the first GAA is disposed in a hotspot of the integrated circuit.

In the foregoing technical solution, a transistor located in the hotspot may also use a GAA transistor structure with a redundant gate, so that thermal efficiency of the hotspot (hotspot) can be further improved, and the heat dissipation performance of the integrated circuit is further improved.

According to a second aspect, this application further provides a power amplifier, and a first amplifier transistor is disposed in the power amplifier. The first amplifier transistor is configured to amplify a signal received by the power amplifier, and the first amplifier transistor includes the first GAA in any one of the foregoing possible implementations.

In the foregoing technical solution, the amplifier transistor is a transistor that carries high thermal power consumption in the PA. Therefore, a GAA transistor that uses a redundant gate in the foregoing embodiment may be first used to improve heat dissipation performance of the PA. Identification of a transistor other than a transistor that mainly causes heat dissipation does not bring the costs of an excessively increased area to the PA.

With reference to any one of the foregoing possible implementations, in a possible implementation, the PA may further include an isolation transistor, configured to implement better isolation between an input terminal (Input) and an output terminal (Output), and the isolation transistor includes the first GAA in any one of the foregoing possible implementations.

In the foregoing technical solution, the heat dissipation performance of the PA can be further improved.

With reference to any one of the foregoing possible implementations, in a possible implementation, the first amplifier transistor is an N-type transistor, a valid gate of the first amplifier transistor is coupled to a signal input terminal (IN) of the PA to receive a to-be-amplified signal, and a redundant gate of the first amplifier transistor is coupled to a ground terminal (GND) of an integrated circuit in which the amplifier is located. A source of the first amplifier transistor is used to be coupled to a ground terminal of the PA.

In the foregoing technical solution, not only the heat dissipation performance of the PA is ensured, but effective amplification of a signal by the PA can also be ensured.

According to a third aspect, this application further provides a power module, a power transistor is disposed in the power module, and the power transistor includes the first GAA in any one of the foregoing possible implementations.

In the foregoing technical solution, the power transistor is a transistor that carries high thermal power consumption in the power module. Therefore, a GAA transistor that uses a redundant gate in the foregoing possible implementations may be first used to improve heat dissipation performance of the power module. Identification of a transistor other than a transistor that mainly causes heat dissipation does not bring the sacrifice of an excessively large area to the power module.

With reference to any one of the foregoing possible implementations, in a possible implementation, the power transistor is coupled between an input and an output of an LDO in the voltage module, a valid gate of the power transistor is coupled to an output terminal of an error amplifier, an input terminal of the error amplifier is a feedback terminal of an output voltage, and the other end is an input terminal of a reference voltage.

In the foregoing technical solutions, because the GAA transistor that uses a redundant gate in the foregoing possible implementations is introduced, heat dissipation performance of the LDO is improved.

With reference to any one of the foregoing possible implementations, in a possible implementation, the power module includes a DCDC, the power transistor includes a first switching transistor and a second switching transistor that are connected in series, and a valid gate (G) of the first switching transistor and a valid gate of the second switching transistor are configured to receive a control signal for enabling and disabling a switch of the corresponding DCDC.

In the foregoing technical solutions, because the GAA transistor that uses a redundant gate in the foregoing possible implementations is introduced, heat dissipation performance of the DCDC can be improved.

According to a fourth aspect, this application further provides a terminal, including the integrated circuit according to the first aspect or any possible implementation of the first aspect, the power amplifier according to the second aspect, or the power module according to the third aspect.

### BRIEF DESCRIPTION OF DRAWINGS

FIG. 1 is a schematic diagram of a structure of a GAA according to an embodiment of this application;
FIG. 2 is a schematic diagram of a structure of another GAA according to an embodiment of this application;
FIG. 3 is a schematic diagram of a structure of a GAA with a redundant gate according to an embodiment of this application;
FIG. 4 is a schematic diagram of a structure of another GAA with a redundant gate according to an embodiment of this application;
FIG. 5 is a schematic diagram of a structure of another GAA with a redundant gate according to an embodiment of this application;
FIG. 6 is a schematic diagram of a power amplifier circuit of a GAA using a redundant gate according to an embodiment of this application;
FIG. 7 is a schematic diagram of circuits of a plurality of single-ended power amplifiers of a GAA using a redundant gate according to an embodiment of this application;
FIG. 8 is a schematic diagram of circuits of a plurality of differential dual-ended power amplifiers of a GAA using a redundant gate according to an embodiment of this application; and
FIG. 9 is a schematic diagram of a power module of a GAA using a redundant gate according to an embodiment of this application.

It should be understood that, in the foregoing schematic diagrams, dimensions and forms of block diagrams are for reference only, and shall not constitute an exclusive interpretation of embodiments of this application. Relative locations and inclusion relationships between the block diagrams presented by the schematic diagrams of structures are merely used as an example to indicate structural associations between the block diagrams, and are not limited to a physical connection manner in embodiments of this application.

### DESCRIPTION OF EMBODIMENTS

Technical solutions provided in this application are further described below with reference to the accompanying drawings and embodiments. It should be understood that a system structure and a service scenario provided in embodiments of this application are mainly intended to explain some possible implementations of the technical solutions of this application, and should not be interpreted as a uniqueness limitation of the technical solutions of this application. A person of ordinary skill in the art may understand that the technical solutions provided in this application may still be applicable to a same or similar technical problem as a system evolves and an updated service scenario appears.

It should be understood that the technical solutions provided in embodiments of this application include a sounding reference signal sending method and a related apparatus. These technical solutions are the same or similar in terms of problem resolving principles. In the following descriptions of specific embodiments, some repeated parts may not be described again. However, it should be considered that there is mutual reference in these specific embodiments and these specific embodiments may be combined with each other.

From an advanced process point, an integrated circuit evolves from a planar FET to a GAA process, and a transistor used as a basic component of the integrated circuit changes from an original planar structure to a 3D structure. A planar channel is disposed on a silicon substrate of the planar FET, and doping is performed on both sides of the channel to separately form a source (Source) and a drain (Drain), and then a gate (Gate) is covered over the source and the drain on a plane and a middle channel region. Compared with a transistor of the planar FET, a gate of a GAA surrounds a periphery of a channel, and a gate surrounds the channel to form a three-dimensional structure. There are separately a source and a drain of the GAA on two sides of the gate channel.

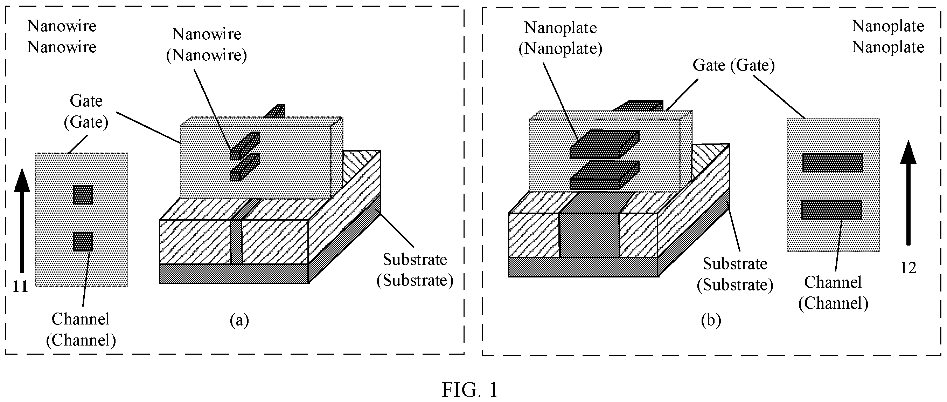

FIG. 1 is a schematic diagram of a structure of a GAA according to an embodiment of this application. As shown in FIG. 1, the GAA currently includes two main implementations. One is shown in (a) in FIG. 1 and is referred to as a nanowire (Nanowire), and the other is shown in (b) in FIG. 1 and is referred to as a nanoplate (Nanoplate). A GAA of a nanowire type uses a linear channel structure, and a horizontal direction of the channel has small width and small height, that is, the channel is in a small channel size. Because the channel size is relatively small, the GAA of the nanowire type is not suitable for a high-power application scenario, and therefore, a commercial scenario is not clear currently. A GAA of a nanoplate type uses a plate-type channel. Because a used nanoplate may have a larger size in a horizontal direction, the GAA of the nanoplate type has larger channel width than the nanowire type, and is suitable for an application scenario of higher power. Currently, the GAA of the nanoplate type is successfully commercialized on a 3 nm process node. Optionally, in a direction perpendicular to a substrate, a plurality of parallel channels may be stacked for either the GAA of the nanowire type or the GAA of the nanoplate type, so that performance of the GAA can be further improved.

Compared to a planar FET, the channel of the GAA is surrounded and controlled by a gate from four side faces. Due to a large contact area, compared with the planar FET, the gate of the GAA can better shut down and control the channel in an advanced process. In an off state, leakage between a source and a drain of the GAA is extremely small. Therefore, compared with the planar FET, the GAA can implement better on and off features and better performance in the advanced process, and therefore becomes a preference of an advanced process node.

However, to further improve a control capability of the gate on the channel, the gate of the GAA entirely surrounds a periphery of the channel, so that the channel becomes a buried layer without being in direct contact with the substrate, and heat generated when a transistor works is difficult to be dissipated by using a silicon substrate, and consequently, temperature in the channel may be far higher than substrate temperature. Due to a smaller transistor size and a smaller chip area, a more advanced process has higher thermal density, but heat dissipation of the GAA further deteriorates.

Further, as shown in FIG. 1, in the direction perpendicular to the substrate, as shown by arrows (11) and (12), generally, a plurality of channels may be further stacked on the GAA, and this makes a heat dissipation problem of the GAA even worse.

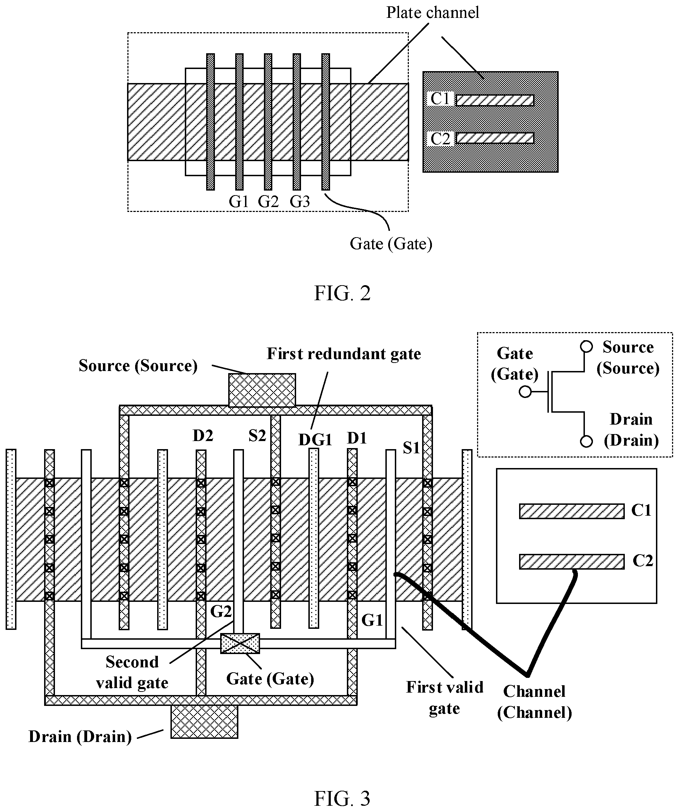

FIG. 2 is a schematic diagram of a structure of another GAA according to an embodiment of this application. When a size of a single transistor based on a GAA structure is relatively large, a plurality of parallel gates are generally used to jointly act on a same channel structure. As shown in FIG. 2, a GAA of a nanoplate type is used as an example, a plurality of gates (gate) surround a same nanoplate, and a space size of the GAA can be fully used in this structure. However, when this structure is used, neighboring gates are affected by a channel in the plate, and a serious heat dissipation problem is caused. Further, when a plurality of parallel plate channel structures are disposed in a vertical direction, this heat dissipation problem further deteriorates. Specifically, as shown in FIG. 2, neighboring gates G1, G2, and G3 are used as an example. When a first channel C1 and a second channel C2 that are parallel between the three neighboring gates are connected to the gate, a current is generated on C1 and C2, and heat is generated, and therefore, a heat dissipation problem is caused. In addition, as a quantity of gates and a quantity of channels increase, a heat dissipation environment deteriorates, and temperature of the gate of the GAA increases more than that of a silicon substrate, and the heat dissipation problem becomes even worse. High temperature not only deteriorates a characteristic of a circuit, but a life span of a component is also significantly shortened during working in a high-temperature mode for a long time, and therefore, reliability of a chip is affected. Therefore, a method for improving heat dissipation of the GAA is urgently needed.

FIG. 3 is a schematic diagram of a structure of a GAA with a redundant gate according to an embodiment of this application. As shown in FIG. 3, as an example, the GAA is a GAA of a nanoplate type, and a valid gate and a redundant gate are disposed around a plate channel. As shown in FIG. 3 as an example, a GAA structure includes a plurality of valid gates that are interlaced in sequence, and a source and a drain located between the valid gates. Specifically, as shown in FIG. 3, a first valid gate (G1) and a second valid gate (G2) are jointly connected to a gate of the GAA, and are configured to connect to a gate voltage. Nanoplate regions on both sides of the first valid gate G1 are a first source (S1) and a first drain (D2), and nanoplate regions on both sides of the second valid gate G2 are a first source (S1) and a first drain (D2). S1 and S2 are jointly connected to a source of the GAA, and are configured to connect to a source voltage. D2 and D1 are jointly connected to a drain of the GAA, and are configured to connect to a drain voltage.

A first redundant gate (DG1) is further disposed between the first valid gate (G1) and the second valid gate (G2), and the DG1 is suspended.

Therefore, when the gate of the GAA is connected to a turn-on voltage, the GAA is on. When a corresponding drain voltage and a corresponding source voltage are respectively applied to the drain and the source of the GAA, an on-current flows through a channel between S1 and D1 and a channel between S2 and D2. When the gate of the GAA is connected to an off-voltage, no turn-on current flows through the channel between S 1 and D 1 and the channel between S2 and D2. However, because the DG1 is suspended, the on-current does not always flow through the channel between S2 and D 1. The gates G1 and G2 connected to the gate are referred to as "valid gates" because the gates G1 and G2 can control on and off of the GAA. The suspended gate DG1 is referred to as a "redundant gate" because the suspended gate DG1 cannot function as an on/off control. As a redundant gate structure is introduced between the valid gates, a current flowing through a unit GAA area is reduced. Therefore, heat dissipation performance of the GAA can be improved based on a structure in which the valid gates are interlaced with the redundant gate.

Further, in a direction perpendicular to the substrate, there may further be two or more channels. As shown in FIG. 3, both sides of the first channel C1 and the second channel C2 on both sides of the valid gate may be jointly connected to the source and the drain of the GAA. In this way, when a transistor is conducted, higher transistor density of the GAA can be implemented.

Further, based on the foregoing GAA structure, in addition to the first redundant gate, a second redundant gate or more redundant gates may be further included between the first valid gate and the second valid gate. In this way, current density in a unit GAA can be further reduced, and the heat dissipation performance is further improved. Optionally, the second redundant gate may be inserted between the first valid gate and the first redundant gate, or the second redundant gate may be inserted between the second valid gate and the first redundant gate.

Generally, to ensure processing implementability, gates of a same GAA transistor are arranged in parallel at equal distances. Therefore, introduction of the foregoing GAA with the redundant gate does not change an existing feature of arrangement at equal distance. FIG. 3 is used as an example. A distance between DG1 and G1 is equal to a distance between DG1 and G2. Certainly, "parallel at equal distances" is a relative concept, and means parallelism at equal distances within a deviation range allowed by existing process precision.

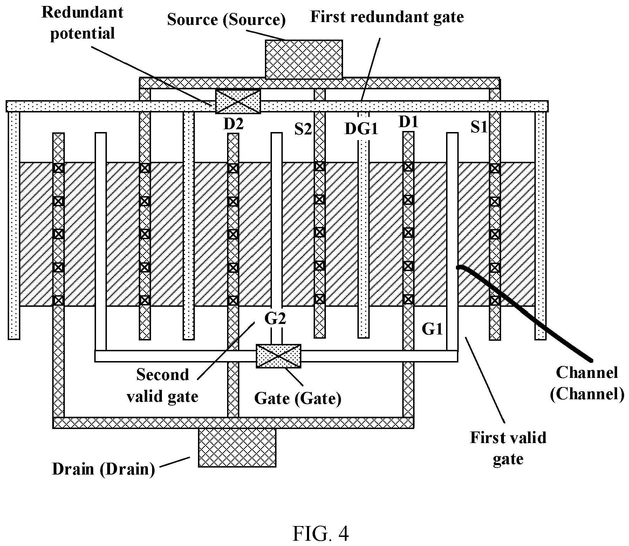

FIG. 4 is a schematic diagram of a structure of another GAA with a redundant gate according to an embodiment of this application. Based on the foregoing embodiment, the redundant gate may be coupled to a redundant potential. The redundant potential is used to keep the redundant gate off, so that channels on both sides of the redundant gate cannot be conducted.

Specifically, when the GAA is an N-type transistor, the redundant potential is a ground terminal (GND) connected to an integrated circuit in which the GAA is located; and when the GAA is a P-type transistor, the redundant potential is a power terminal (VDD) connected to the integrated circuit in which the GAA is located. The integrated circuit is coupled to a power potential and a ground potential outside the integrated circuit by using the ground terminal and the power terminal.

Compared with a suspended redundant gate, the redundant gate connected to the redundant potential can prevent a case in which the redundant gate is enabled by mistake due to uncertainty caused by suspension. In addition, because the redundant gate is connected to the GND or the VDD of the integrated circuit, a part of heat generated by the GAA may be exported to an outer side of the integrated circuit by the redundant gate by using a connection wire between the GND and the VDD, to further improve heat dissipation performance.

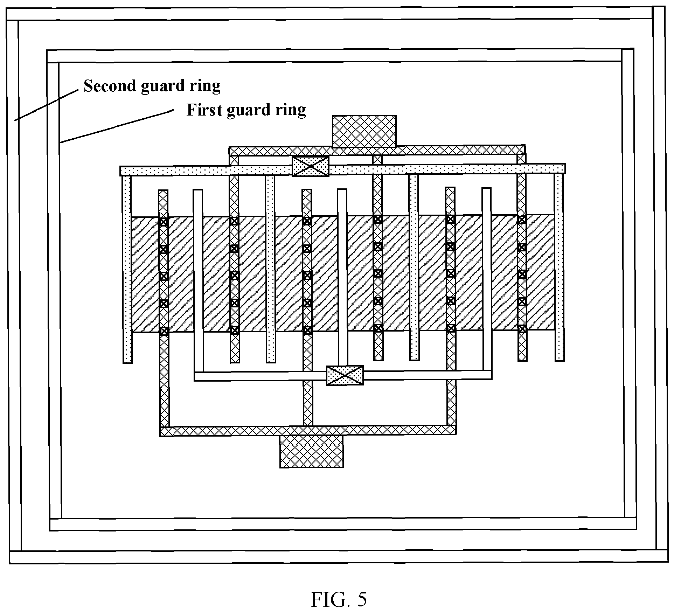

FIG. 5 is a schematic diagram of a structure of another GAA with a redundant gate according to an embodiment of this application. Based on the foregoing embodiment, a guard ring (guard ring) may be disposed on one or more sides of the GAA, the guard ring may be closed or may have a plurality of notches, and there may be one or more guard rings around the GAA.

Specifically, as shown in FIG. 5, a first guard ring is disposed around the GAA. The first guard ring may be closed, or may have a plurality of openings. The first guard ring may alternatively be disposed on only one side of the GAA.

Further, based on the first guard ring, a second guard ring may be further disposed on the integrated circuit, and the first guard ring is disposed between the second guard ring and the GAA. Similar to the first guard ring, the second guard ring may be disposed around the GAA, or the second guard ring may be disposed on only one side of the first guard ring. The second guard ring may be closed, or may have a plurality of openings.

A specific type of the guard ring varies with the GAA. Specifically, when GAA is a P-type transistor, the first guard ring is an N-type guard ring, and the second guard ring is a P-type guard ring. When GAA is an N-type transistor, optionally, for example, is a type of a deep n-well (deep Nwell), the first guard ring is a P-type guard ring, the second guard ring is an N-type guard ring, and a third guard ring that is a P-type guard ring may be further disposed outside the second guard ring.

Because the guard ring is introduced, a substrate of the GAA may be connected to a ground terminal or a VDD terminal of the integrated circuit by using the guard ring, and disposing on a single side or a plurality of sides and open or closed disposing may be performed based on an actual chip area layout. In this way, based on the foregoing redundant gate, heat dissipation performance of the GAA based on a guard ring structure can be further improved.

It should be noted that, although the GAA based on the redundant gate in this embodiment of this application can implement better heat dissipation performance, and extra area costs are paid in a redundant gate structure, a circuit module with a high heat dissipation requirement is identified, and a specific transistor is specifically identified in the circuit module. Therefore, using the redundant gate-based structure is also a problem that needs to be considered during chip design.

When a chip works, some partial regions generate heat higher than another region, and these regions are referred to as a hotspot (hotspot). Some or all transistors in the hotspot may use the GAA transistor structure with the redundant gate described in the foregoing embodiment, and this helps reduce heat generation of the hotspot. The hotspot may be a specific analog function module, such as a power amplifier or a power module, or may be a digital operation module, such as a CPU, a GPU, or a storage module.

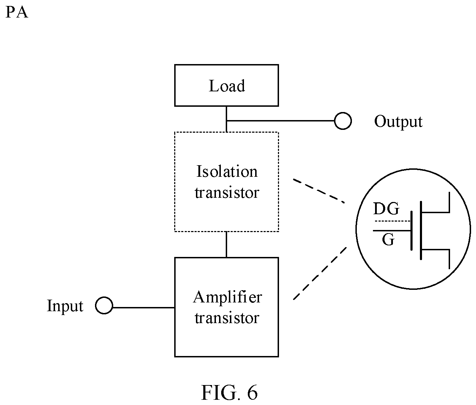

FIG. 6 is a schematic diagram of a power amplifier circuit of a GAA using a redundant gate according to an embodiment of this application. The power amplifier circuit (PA: power amplifier) is an important functional circuit in a wireless communication system, and is configured to amplify power of a transmit signal. The PA is a circuit with an extremely high requirement on heat dissipation of a chip. A system of the PA is complex, and an overall layout area of the PA is relatively large. Therefore, when all transistors of the PA use the structure in the foregoing embodiment, a problem of an excessively large area may be caused. A core transistor in the PA is identified, and the GAA structure with the redundant gate described in the foregoing embodiment may be used to optimize the area while improving the heat dissipation performance.

Specifically, as shown in FIG. 6, the PA includes an amplifier transistor and a load. One end of the amplifier transistor is coupled to an input terminal (Input) of the PA, and is configured to receive an input signal and amplify the input signal. The other end is coupled to an output terminal (Output) of the PA. The load coupled to the output terminal is configured to provide impedance matching of an output signal. The amplifier transistor is a transistor that carries high thermal power consumption in the PA. Therefore, the GAA transistor with the redundant gate in the foregoing embodiment may be used to improve heat dissipation performance of the PA. Because a transistor that mainly causes heat dissipation is identified, the sacrifice of an excessively large area is not brought to the PA.

Further, the PA may further include an isolation transistor, configured to better isolate the input terminal (Input) and the output terminal (Output). Because a large current also flows through the isolation transistor, the redundant gate structure may also be used, to further improve the heat dissipation performance of the PA.

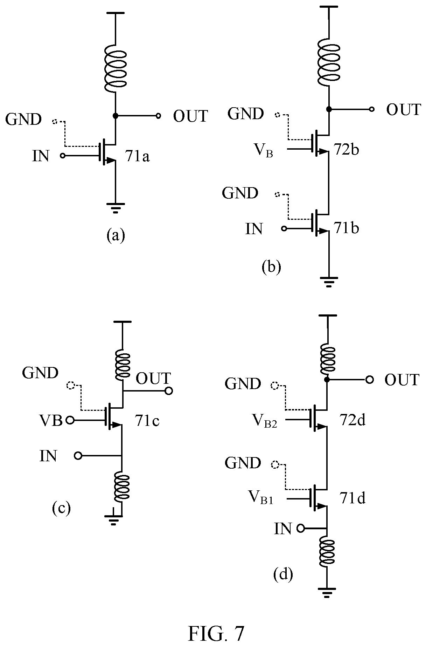

FIG. 7 is a schematic diagram of circuits of a plurality of single-ended power amplifiers of a GAA using a redundant gate according to an embodiment of this application. Specifically, (a) in FIG. 7 shows a PA of a common-source amplification architecture, an amplifier transistor 71a is an N-type transistor, and a valid gate of the N-type transistor is coupled to a signal input terminal (IN) of the PA, and is configured to receive a to-be-amplified signal. A redundant gate of the N-type transistor is coupled to a ground terminal (GND) of an integrated circuit in which the N-type transistor is located. A source of the N-type transistor is configured to be coupled to a ground terminal of the PA, as shown in the figure. Optionally, there may be a matching component or another type of FET transistor between the N-type transistor and the ground terminal. A drain of the N-type transistor is configured to be coupled to an output terminal (OUT), and output an amplified signal. The output terminal is coupled to a load inductor used for matching.

Further, an isolation transistor may be further included between an amplifier transistor of a common-source amplifier and the load. As shown in (b) in FIG. 7, an amplifier transistor 71b and an isolation transistor 72b constitute a cascoded (cascode) amplification structure. The amplifier 71b is an N-type transistor, and 72b is also an N-type transistor. As valid gate of 71b is configured to receive an input signal (IN) of the PA, a valid gate of 72b is configured to receive a bias voltage (VB: voltage bias), and redundant gates of 71b and 72b may be separately coupled to a ground terminal (GND).

In addition to an architecture of the common-source amplifier, the power amplifier circuit may be further based on a common-gate architecture. As shown in (c) in FIG. 7, an amplifier transistor 71c is an N-type transistor, a valid gate of 71c is configured to receive a bias voltage (VB), and a redundant gate of 71c is configured to be grounded (GND). A source of 71c is configured to be coupled to the input terminal (IN) and receive a to-be-amplified signal. A drain of 71c is configured to be coupled to a load terminal (OUT) and output an amplified signal. An inductor is coupled between the source of 71c and the ground, and the drain of 71c is also coupled to a power terminal by using an inductor.

Further, the common-gate amplifier may further include an isolation transistor. As shown in (d) in FIG. 7, an N-type transistor of 72d may be further included between 71d of the amplifier transistor and a load terminal, and a valid gate of 72d is configured to receive a proper bias voltage (VB2: voltage bias), a redundant gate of 72d is also coupled to the ground terminal.

Optionally, redundant gates of all or some of the amplifier transistors and the isolation transistors shown in FIG. 7 may also be suspended.

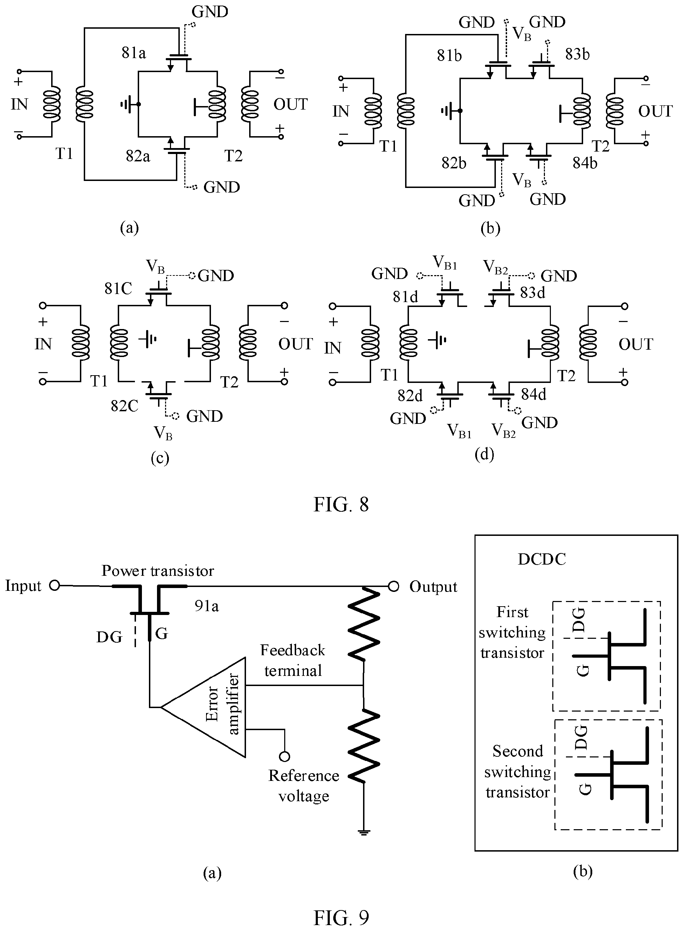

FIG. 8 is a schematic diagram of circuits of a plurality of differential dual-ended power amplifiers of a GAA using a redundant gate according to an embodiment of this application. Based on a single end in (a) in FIG. 7, as shown in (a) in FIG. 8, a differential signal received by an input terminal (IN) of a PA is coupled to valid gates of two amplifier transistors 81a and 82a by using an input transformer coil T1, and redundant gates of the two amplifier transistors are coupled to a ground terminal. Differential signals output from drains of the two amplifiers are coupled to an output terminal (OUT) of the PA by using an output transformer coil T2. Sources of the two amplifiers may be directly grounded or grounded by using matching components.

Similarly, an isolation transistor may be further included between an output signal and differential amplifier transistors, as shown in (b) in FIG. 8. Based on (a) in FIG. 8, differential amplifier transistors 81b and 82b in (b) in FIG. 8 are respectively coupled to the output transformer coil T2 by using two isolation transistors 83b and 84b.

In addition to a differential common-source amplifier architecture, differential dual-ended power amplifiers may also use the differential common-gate amplifier architecture, as shown in (c) in FIG. 8 and (d) in FIG. 8. Based on the single-ended architecture shown in (a) in FIG. 7 and (b) in FIG. 7, differential signals coupled to the input transformer T1 and received by differential input terminals (IN) are separately coupled to sources of the two amplifiers 81c and 82c, and drains of the two amplifiers are configured to output the differential signals, so that the differential signals are coupled to the output terminal by using the output transformer T2. Valid gates of the amplifiers 81c and 82c are configured to be coupled to a bias voltage (VB1) to establish a direct-current operating point. Redundant gates of the two amplifiers are separately coupled to the ground terminal.

Further, based on (c) in FIG. 8, as shown in (d) in FIG. 8, isolation transistors 83d and 84d may be further coupled between the output and the two amplifier transistors 81d and 82d. A connection manner of a valid gate and a redundant gate of the isolation transistor is the same as that of the isolation transistor shown in (d) in FIG. 7.

Optionally, redundant gates of all or some of the amplifier transistors and the isolation transistors shown in FIG. 8 may be suspended or grounded.

FIG. 9 is a schematic diagram of a power module of a GAA using a redundant gate according to an embodiment of this application. Based on the foregoing embodiments, the power module is also an important circuit module for which heat dissipation needs to be considered during chip design. Similar to the power amplifier, for the power module, a power transistor is preferred for improving heat dissipation under a chip area constraint. When the GAA structure with the redundant gate described in the foregoing embodiments is introduced into a power transistor, heat dissipation performance of the power module can be improved, and an area can also be optimized.

A low dropout linear regulator (LDO: low drop out regulator) shown in (a) in FIG. 9 is one of typical power modules. As shown in the figure, because a power transistor in the LDO bears a large output current, and generates a large amount of heat, a power transistor 91a may use a GAA transistor with a redundant gate, so that thermal efficiency of the LDO is improved. The power transistor 91a is coupled between an input and an output of the LDO, and a valid gate of 91a is coupled to an output terminal of an error amplifier. An input terminal of the error amplifier is a feedback terminal of an output voltage, and the other end is an input terminal of a reference voltage. A redundant gate of the power transistor 91a may be suspended or connected to a redundant potential.

(b) in FIG. 9 shows a direct-current to direct-current converter (DCDC: Direct current to direct current converter). Power transistors of the DCDC are a first switching transistor and a second switching transistor shown in the figure. In the DCDC, the two transistors bear a large output current and generate a large amount of heat. The two transistors may use a redundant gate-based GAA structure, so that thermal efficiency of the DCDC is improved. Valid gates (G) of the first switching transistor and the second switching transistor are configured to receive an on/off control signal for a corresponding switch, and the redundant gate may be suspended, or may be connected to a redundant potential.

Specifically, the DCDC may be a closed-loop architecture such as a buck (buck) architecture, a boost (boost) architecture, or a buck-boost (buck-boost) architecture, or may be an open-loop architecture such as a charge pump (charge pump).

The chip in the foregoing embodiments of this application may be used in various terminals. The terminal may be a mobile phone (mobile phone), a tablet computer (tablet computer), a laptop computer (laptop computer), a wearable device (such as a smart watch, a smart band, a smart helmet, or smart glasses), and another device that has a wireless access capability, such as a smart car, a mobile wireless router, various internet of thing (internet of thing, IOT) devices, including various smart home devices (such as a smart meter and a smart home appliance), and smart urban devices (such as a security or monitoring device and a smart road traffic facility).

Terms "first", "second", "third", and the like in embodiments of this application and the accompanying drawings are used to distinguish between similar objects, and do not need to be used to describe a specific order or sequence. In addition, terms "include" and "have" as well as any of their deformations are intended to cover non-exclusive inclusion, for example, a method, a system, a product, or a device including a series of steps or units is not necessarily to be limited to the clearly listed steps or units, but can include other steps or units that are not clearly listed or inherent steps or units of the process, the method, the product, or the device.

In this application, "at least one" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. "At least one of the following items (pieces)" or a similar expression thereof indicates any combination of these items, including a single item (piece) or any combination of a plurality of items (pieces). For example, at least one of a, b, or c may indicate a, b, c, "a and b", "a and c", "b and c", or "a, b, and c", where a, b, and c may be singular or plural.

It should be understood that sequence numbers of the foregoing processes do not mean execution sequences in embodiments of this application. The execution sequences of the processes should be determined according to functions and internal logic of the processes, and should not be construed as any limitation on the implementation processes of embodiments of this application. The term "coupling" mentioned in this application is used to express interworking or interaction between different components, and may include a direct connection or an indirect connection by using another component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated circuit, comprising:
a first gate all around field effect transistor GAA, wherein a first valid gate, a second valid gate, and a first redundant gate are disposed in the first GAA, and the first redundant gate is disposed between the first valid gate and the second valid gate;
the first valid gate, the second valid gate, and the first redundant gate surround a periphery of a first channel;
the first valid gate and the second valid gate are connected to a gate of the first GAA;
two sides of the first channel surrounded by the first valid gate and the second valid gate are separately connected to a source and a drain of the first GAA; and
the first redundant gate is connected to a redundant potential or is suspended.

2. The integrated circuit according to claim 1, further comprising:
a second channel, wherein the second channel and the first channel are arranged in parallel in a direction perpendicular to a substrate of the first GAA;
the first valid gate, the second valid gate, and the first redundant gate surround a periphery of the second channel; and
two sides of the second channel surrounded by the first valid gate and the second valid gate are separately connected to the source and the drain of the first GAA.

3. The integrated circuit according to either of claims 1 and 2, further comprising:
a second redundant gate, wherein the second redundant gate is located between the first valid gate and the first redundant gate; and
the second redundant gate is connected to the redundant potential or is suspended.

4. The integrated circuit according to any one of claims 1 to 3, wherein
the first GAA is N-type, and the redundant potential is coupled to a ground terminal of the integrated circuit.

5. The integrated circuit according to claim 4,
further comprising a first guard ring, wherein
the first guard ring is disposed on one or more sides of the N-type first GAA; and
the first guard ring is a P-type guard ring.

6. The integrated circuit according to any one of claims 1 to 3, wherein
the first GAA is P-type, and a terminal of the redundant potential is coupled to a power terminal of the integrated circuit.

7. The integrated circuit according to claim 6,
further comprising a first guard ring, wherein
the first guard ring is disposed on one or more sides of the P-type first GAA; and
the first guard ring is an N-type guard ring.

8. The integrated circuit according to claim 5 or 7, wherein
one or more openings are disposed on the first guard ring.

9. The integrated circuit according to any one of claims 1 to 8, wherein
the first GAA is disposed in a hotspot of the integrated circuit.

10. The integrated circuit according to any one of claims 1 to 9, wherein
the first channel is a nanoplate or a nanowire.

11. A power amplifier,
comprising a first amplifier transistor, wherein
the first amplifier transistor is configured to amplify a signal received by the power amplifier; and
the first amplifier comprises the first GAA according to any one of claims 1 to 10.

12. A power module,
comprising a power transistor, wherein the power transistor comprises the first GAA according to any one of claims 1 to 10.

13. A terminal,
comprising the integrated circuit according to any one of claims 1 to 10, the power amplifier according to claim 11, or the power module according to claim 12.
